(19) Europäisches Patentamt
European Patent Office
Office européen des brevets

(11) EP 1 521 384 A2

(12) **EUROPEAN PATENT APPLICATION**

(43) Date of publication:
**06.04.2005 Bulletin 2005/14**

(51) Int Cl.[7]: **H04L 1/00**

(21) Application number: **03020106.5**

(22) Date of filing: **04.09.2003**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **20.08.2003 EP 03018926**

(71) Applicant: **SIEMENS AKTIENGESELLSCHAFT**
**80333 München (DE)**

(72) Inventors:
- **Jenkac, Hrvoje**
  **81373 München (DE)**
- **Kaindl, Markus**
  **85221 Dachau (DE)**
- **Liebl, Günther**
  **85356 Freising (DE)**
- **Stockhammer, Thomas**
  **83346 Bergen (DE)**

(54) **A method for transmitting a multimedia message**

(57) A method for transmitting a multimedia message via an air interface comprising radio link control segmentation, encoding of the data segments with any channel code, interleaving/distribution of resulting channel code word over **several** single user transmission slots, and channel decoding/reconstruction at the receiver. Specific realizations are discussed.

FIG 2

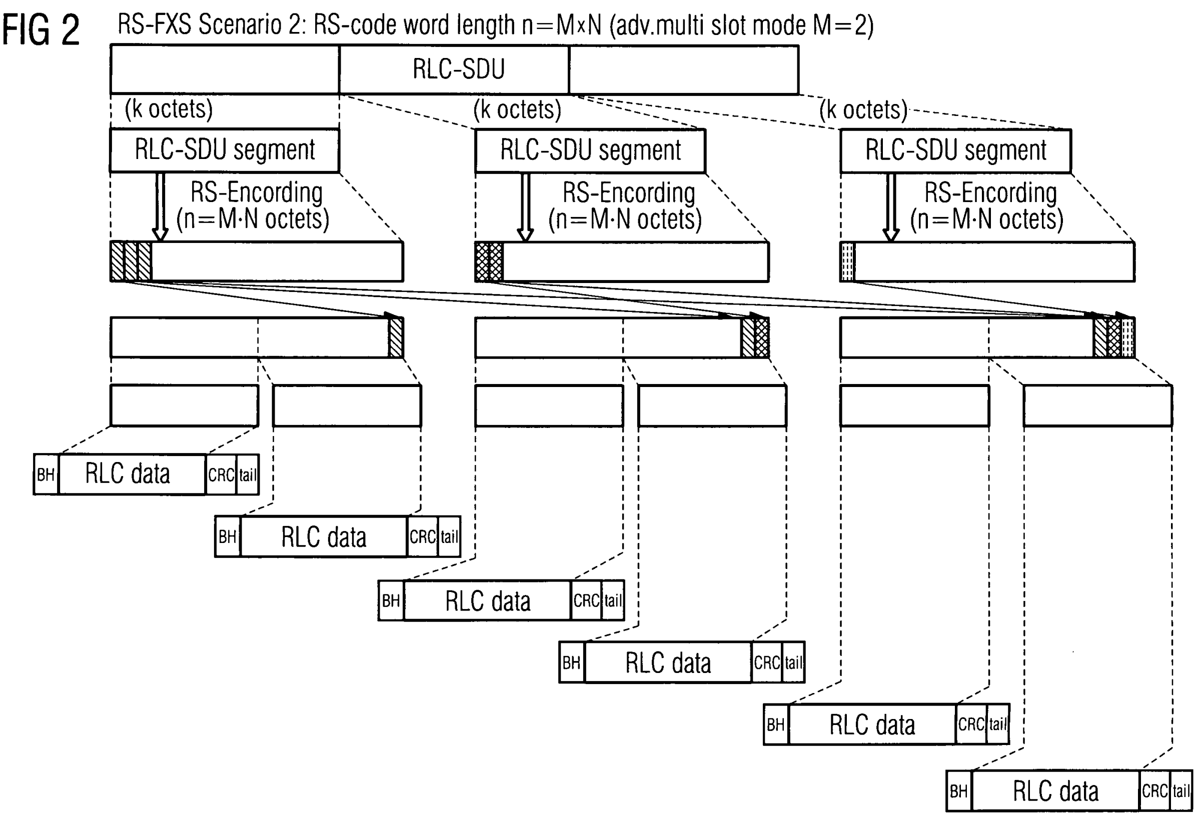


EP 1 521 384 A2

## Description

This invention relates to a method for transmitting a message over multiple transmission slots.

Typical MBMS services could be data, software, audio, or video clip distribution to a large group of users resulting in real-time or non real-time transmission scenarios.

The purpose of the current standardization effort is to provide a stage 2 description of the changes required in existing specifications for the "Introduction of the Multimedia Broadcast Multicast Service (MBMS) in GERAN" feature for Release 6. In Section 5.1 of document 3GPP TR 25.992-140 "Multimedia Broadcast/Multicast Service (MBMS); UTRAN/GERAN requirements" □[1] (UTRAN = Universal Terrestrial Radio Access Network, GERAN = GSM/EDGE Radio Access Network) the following requirements are listed:

1. MBMS data transfer shall be downlink only.

2. QoS attributes shall be the same for MBMS Multicast and Broadcast modes.

3. Reception of MBMS shall not be guaranteed at RAN level. MBMS does not support individual retransmissions at the radio link layer, nor does it support retransmissions based on feedback from individual subscribers at the radio level.

4. During MBMS data transmission it shall be possible to receive paging messages, which also should contain some additional information, such as CLI.

5. Simultaneous reception of MBMS and non-MBMS services shall depend upon UE (UE = User Equipment) capabilities.

6. Simultaneous reception of more than one MBMS services shall depend upon UE capabilities.

7. A notification procedure shall be used to indicate the start of MBMS data transmission. This procedure shall contain MBMS RB information. The MBMS notification requirements and recommendations are listed in sub-clause 5.3.

8. A mechanism to enable the Network to move MBMS subscribers between cells is required.

9. Cell selection-reselection, handover, and SGSN, SRNS/SBSS relocation shall not be affected by an active MBMS session.

10. MBMS UE multicast activation (Joining) shall be transparent to UTRAN/GERAN.

11. A mechanism is required that enables the non-transmission of MBMS multicast mode in a cell which does not contain any MBMS UEs joined to the multicast group.

12. A mechanism to provide UTRAN the received QoS per UE is not required as part of MBMS.

13. In the case of UTRAN only, guaranteed 'QoS' linked to a certain initial downlink power setting is not required.

The following recommendations have been listed in Section 5.2 in 3GPP TR 25.992-140 □[1]:

1. MBMS Multicast mode transmissions should use dedicated resources (p-t-p) or common resources (p-t-m). The selection of the connection type (p-t-p or p-t-m) is operator dependent, typically based on downlink radio resource environment such as radio resource efficiency. A "threshold" related to the number of users may be utilised, resulting in the need for a mechanism to identify the number of subscribers in a given "area".

2. MBMS solutions to be adopted should minimise the impact on the RAN physical layer and maximise reuse of existing physical layer and other RAN functionality.

3. MBMS charging should be transparent to the RAN.

4. MBMS should allow for low UE power consumption.

5. Header compression should be used.

6. MBMS should not prevent support for SGSN in pool.

7. Data loss during cell change should be minimal.

The introduced invention addresses and solves particularly several of the listed requirements and recommendations, namely requirements 1 and 3 as well as recommendations 1 and 2. In addition, the invention does not conflict with any other requirements or recommendations. Especially requirement 3 and recommendation 2 are taken into account.

At present, only two types of logical traffic channels are defined within GERAN: dedicated channels and packet switched channels. As MBMS is a service provided over the packet-switched domain, dedicated channels are not suitable for it. The only packet switched channel is the PDTCH (Packet Data Traffic CHannel). Siemens already proposed to introduce a new logical channel, called MDTCH (Multicast Data Traffic CHannel) to support a point-to-multipoint (p-t-m) transmission. According to requirement 3 individual retransmissions on the radio link layer will not be supported as necessary for the acknowledged mode in GERAN or UTRAN. This is a downlink only channel and, on this channel, the RLC would operate in unacknowledged mode. Therefore, reliable transmission of data can not be guaranteed. Typical RLC/MAC block loss rates for all four GPRS coding schemes over a TU03 channel with and without frequency hopping at C/I=7dB are shown in Table 1 along with the payload size of each coding scheme[1].

Table 1

| Payload size and RLC/MAC block loss rates at C/I=7dB, different coding schemes with and without frequency hopping. | | | |
|---|---|---|---|
| | Payload size N | 7dB FH | 7dB nFH |
| CS 1 | 20 bytes | 0.133680 | 0.252568 |
| CS 2 | 30 bytes | 0.410720 | 0.337416 |
| CS 3 | 36 bytes | 0.595024 | 0.397168 |
| CS 4 | 50 bytes | 0.929472 | 0.568128 |

For an expected C/I of 7dB, a typical RLC-SDU (Radio Link Control - Service Data Unit) size of 500 bytes, and the assumption of statistically independent RLC/MAC block losses the resulting RLC-SDU error rate for CS-1 is around 97%, i.e. unacceptable. Therefore, methods are required to reduce the RLC-SDU error rate significantly. Simple repetition schemes as proposed and discussed in detail in the next section are not sufficient. The superiority of our new approach compared to these proposals in terms of achievable throughput under similar system constraints will be discussed later in detail. In addition, not necessarily a certain C/I value at a given residual error rate is the objective for support within a cell, but the percentage of supported users. Therefore, a flexible coding approach with parameter adjustments should provide benefits. The invention can be applied not only to GERAN MBMS, but also to any other packet loss channels with similar characteristics. However, we will focus on the latter system in the following to avoid a too superficial description. The final patent might be formulated in a more general way.

In the following we will distinguish between proposals in the MBMS GERAN standardization, MBMS UTRAN standardization, proposals and solutions in other standards, and technology which has been published previously in the literature for similar purposes, but has not (yet) been included in any standards to the best of our knowledge.

MBMS GERAN standardization efforts:

Given that for MBMS p-t-m streams data is sent in unacknowledged mode as no feedback from the users is possible, one of the methods that have been proposed to reduce the SDU error rate is to use "repetition redundancy". Several options are possible for the addition of repetition redundancy: One method could be to add the redundancy at the BM-SC: each SDU would be repeated K times. This is clearly described in subclause 6.7 of TR 23.846 □[3], which states that one of the BM-SC functions is:

"MBMS data repetition and error resilient schemes to cope with possible transmission loss".

This is the solution that has the lowest possible impact on the GPRS core network and on the GERAN. An alternative option would be to add the redundancy in the RAN: each RLC/MAC block is repeated K times in the BSC[2].

[1] Due to imperfections in the RF part of the transmitter and receiver, a 2dB margin has to be obeyed when stating simulated performance results. Hence, for the MBMS target of 9dB, discrete-time simulations at baseband have to be performed at 7dB.

[2] These *K* replicas could then be either sent sequentially, or each replica could be sent a certain number of blocks after the previous one (and in between, replicas of other blocks would be sent). This would provide additional time diversity gain.

For example, a scheme for the UTRAN has been investigated in which the Node B repeats each transport block a specified number of times, and the receiver performs soft combining of the received replicas of each block. A similar scheme could also be used in the GERAN, with or without soft combining. Without soft combining, the receiver would just decode each replica of a block independent of all others, and the block is correctly received if at least one of the replicas is received correctly, see □[5]□[6]□[7] .

Instead of repeating the same RLC/MAC block K times, one possible alternative could be to use Incremental Redundancy (this is suitable only in situations where puncturing is performed, see □[8]). For example, instead of using a rate 1/n convolutional code to encode the RLC/MAC blocks and then send the same block K times (i.e. K exact replicas of the same encoded block), it may be possible to use a rate $1/(K \cdot n)$ code, and use K different puncturing patterns to produce K different redundancy versions of the same block. These K different redundancy versions could then either be sent sequentially, or each of them could be sent a certain number of blocks after the previous one. The receiver would then combine as many redundancy versions as required to perform a correct decoding of the block. It certainly requires significant additional complexity both in the network and in the MS. Although within the standardization this scheme is denoted as incremental redundancy, this terminology is misleading: The proposal is identical to use a new channel coding scheme with a specific interleaver.

All proposals assume that an MDTCH will be mapped on one PDCH (it will have the same multiframe structure as the PDTCH). For transmission on multiple timeslots, one MBMS service will use multiple MDTCHs in parallel.

MBMS UTRAN standardization

Note that other methods than repetition of data blocks have been proposed in order to reduce the SDU error rate. One of them is the use of coding at the application layer ("outer coding"). This is described, for example, in □[9], where a serial concatenated code for the MBMS channel is proposed:

1. Outer code - [n, k] Reed-Solomon (RS) code with no CRC

    a. There are k information rows and (n-k) parity rows.

    b. RS decoding is done for every shaded column.

2. Inner code - rate 1/3 turbo code with a 16-bit CRC

    a. Each inner block of 20 ms TTI spans 1 row of the outer block.

    b. Eight information bits of the inner code correspond to one outer code symbol.

3. Number of outer blocks - fixed, based on UE buffer size

Note that this proposal is exclusively for UTRAN and the interleaver is a block interleaver.

Other Standards:

We will focus on other standards which either describe transmission schemes for packet loss channels or apply a concatenated coding scheme.

The first class describes forward error correction for packet loss channels. Several schemes are known. In all cases the decoder is a simple erasure decoder, as the data symbols are only erased, but not altered on the channel.

In approaches as presented in RFC 2733 □[9] a backward-compatible pure packet-based forward error correction using binary codes is applied. In this case the initial data packets are sent unaltered. In addition, parity packets are generated and sent, which allow smart receivers to combine correctly received packets to reconstruct lost ones.

An overview of techniques to combat packet losses is presented in RFC 2354 □[9]. Among others, non-binary RS codes are mentioned to be useful and appropriate pointers to publications and other standards are provided.

For both approaches, binary and RS codes, extensions to unequal erasure protection (UXP) and scalable source coding are currently discussed □[9], which, however, are of little relevance to the presented inventions as scalable source coding is currently not encouraged within MBMS.

An application of one of these presented schemes would be possible within the context of MBMS at the application layer. However, this involves two significant drawbacks: Firstly, the redundant information is not added at the link layer, but at end-to-end level. This increases bandwidth on the access network and complicates adaptation to the current transmission conditions as end-to-end signalling would be necessary. Secondly, and probably even more important, is the fact that adaptation to the underlying packet structure can not be exploited. In case of the loss of just a single RLC/MAC block the entire IP packet is in general declared lost. Therefore, the loss rate of longer IP packets is rather high, which complicates the reconstruction.

Other standards include serially concatenated coding with any inner code and an outer RS code. Examples include deep space error correction schemes, DVB-T, DVB-S, GSM ECSD systems with inner convolutional codes, error protection for Compact Discs (CD) with inner RS codes, and systems with inner Turbo codes. Inner and outer coding is in general connected via a specific interleaving procedure to avoid burst errors/erasures. Whereas CDs and Turbo codes apply block interleaving, in DVB a convolutional interleaver is applied, which is beneficial due to its constant delay and its excellent spreading properties. However, DVB, as well as all other standards, have been designed for different purposes than MBMS, i.e. all parameters have been adjusted appropriately. For example, the parameters of the RS code are fixed to the specific application and the convolutional interleaver is adapted to the inner and outer coding. In addition, the outer RS decoder is in general an error decoder, as the inner code usually does include error detection capabilities.

Literature:

In the literature many other schemes are known for different purposes. For the transmission of data over packet loss channels multiple description coding □[9] has been proposed. However, this approach has several drawbacks: inefficiency, complicated multimedia encoders and decoders, and required end-to-end adaptation. A possible realization of multiple description coding is the combination of UXP and scalable source coding □[20], which has been discussed in many publications recently. However, the same drawbacks as mentioned for general multiple description coding also hold for this scheme. Decoding algorithms for RS codes are known which are not exclusively error or erasure decoders. Soft decoding of RS codes might help to improve the overall system of concatenated coding schemes□[22]. This also includes principles such as iterative decoding of serially concatenated codes with outer RS codes □[23].

In addition to RS codes different packet erasure codes are known. For example, Tornado codes □[29] have been proposed to be used in high-speed applications as they have slightly lower efficiency than RS codes, but encoding and decoding is significantly less complex. However, for our proposed block lengths this seems to be of little relevance. In principle for MBMS new advanced channel coding schemes could be designed including Turbo codes, low-density parity check (LDPC) codes, etc., as the delay in MBMS is less critical and, therefore, codes with longer block lengths are applicable. However, this requires a redesign of the RAN layer, which should be avoided according to recommendation 2.

Based on the foregoing description it is an object of the invention to provide a method for transmitting multimedia messages that enables a performance improvement compared to prior art.

The object of the invention will be achieved with a method for transmitting multimedia messages, which is defined by what is disclosed in the appended independent claim. Advantageous embodiments of the present invention will be presented in the dependent claims.

**Advanced multi slot transmission scheme yielding additional coding gain.**

In the simple extension for multi-slot transmission it is proposed to interleave one RS codeword only over RLC/MAC blocks on the same MDTCH, thus achieving *M* times the data rate or throughput of the single slot case (with *M* being the number of parallel MDTCHs/time slots to be used).

However, there exists a more advanced strategy, which yields an additional coding gain by making use of longer code word lengths n and still having reasonable delay. This can be accomplished by combining different slots in one code word.

A specific realization is presented in the following. We propose to perform interleaving of a single RS codeword over all *M* MDTCHs. Thus, we can increase the code word length to $n=N*M$, thereby achieving significant coding gains. A specific realization using a convolutional interleaver which minimizes the delay for a single RLC-SDU is discussed in the following. The algorithm can be summarized as follows:

1. Generate a code word of length n=M*N symbols (bytes).
2. The first symbol (byte) of the RS code word generated at time *i* is placed in RLC/MAC block *i* on time slot *M* at position *N*.
3. The second symbol (byte) of the RS code word generated at time i is placed in RLC/MAC block i+1 on time slot M at position N-1.
4. ...
5. The N-th symbol (byte) of the RS code word generated at time i is placed in RLC/MAC block i+N-1 on time slot M at position 1.
6. The (N+1)-th symbol (byte) of the RS code word generated at time i is placed in RLC/MAC block i+N on time slot M-1 at position N.
7. ...
8. The (*M***N*)-th symbol (byte) of the RS code word generated at time *i* is placed in RLC/MAC block *i*+*M***N*-1 on time slot 1 at position 1.

An example for the case of M=2 is shown in the attached powerpoint file: Figure 1 shows the conventional scheme, Figure 2 the proposed scheme.

In the following an estimation of the performance gains achieved by preferred embodiments of the invention is presented.

1.1 Definitions

*S* RLC-SDU size (in bytes), where RLC = Radio Link Control, SDU = Service Data Unit.

*M* number of parallel MDTCHs (or time slots used at the physical layer)

*N* payload size of RLC/MAC blocks (in bytes); depends on coding scheme, where MAC = Medium Access Control.

*n* RS code word length (in symbols or bytes) *p* RLC/MAC block loss rate

*k* size of RLC-SDU segments (in bytes), corresponds to RS information word length (in symbol or bytes)

$p_s$ RLC-SDU segment loss rate

*K* number of repetitions for repetition schemes

$P_s$ residual RLC-SDU error rate

*T* transmission time interval of RLC/MAC blocks (20 ms in GSM-GPRS)

*Z* throughput of the applied coding scheme (in bit/s)

*D* minimum delay of an RLC-SDU assuming immediate transmission.

1.2 SDU Error Rate Estimation

In the following we estimate the performance of RLC-SDU error rates and compare the results to existing proposals. The RLC-SDU error rate estimation is very similar to the computations presented in Tdoc GMBMS-030007 □[6]. We assume statistically independent RLC/MAC block losses. We will briefly review those as we also use them for comparison purpose. For the K-times repetition of RLC-SDUs the resulting error rate can be estimated as

$$P_S = \left[1-(1-p)^{\lceil S/N \rceil}\right]^K$$

For K-times repetition of RLC/MAC blocks the residual error rate can be estimated as

$$P_s = 1-(1-p^K)^{\lceil S/N \rceil}.$$

For the new scheme a similar estimation can be used. In this case, however, we first have to estimate the loss rate of an RLC-SDU segment corresponding to a RS code word. This can be estimated as

$$p_S = \sum_{i=n-k+1}^{n} \binom{n}{i} p^i (1-p)^{n-i} .$$

Then, assuming statistical independent losses of the segments[3] the residual RLC-SDU error rate can be estimated as

$$P_S = 1-(1-p_s)^{\lceil S/k \rceil}.$$

1.3 Throughput Estimation

The throughput is defined as the maximum transmission data rate which is supported by a specific coding scheme in bit/second. The throughput for both repetition schemes can be estimated as

$$Z = \frac{8 \cdot N \cdot M}{T \cdot K}.$$

For the RS scheme the throughput can be estimated as

$$Z = \frac{k}{n} \cdot \frac{8 \cdot N \cdot M}{T} = \frac{k \cdot 8}{T}.$$

1.4 Delay Estimation

Although the repetition scheme has not been presented in detail yet we estimate the delay for a single RLC-SDU which is immediately transmitted without being queued. For both repetition schemes we obtain the following delay:

$$D = \frac{K \cdot T}{M} \left\lceil \frac{S}{N} \right\rceil .$$

For the RS code scheme with convolutional interleaver the delay can be estimated as:

$$D = \left( \left\lceil \frac{S}{k} \right\rceil + n \right) T .$$

2 Results and Comparison

2.1 GPRS Parameters

In the following we will present performance estimations for typical scenarios. For this, we have gathered RLC/MAC block loss rates for all four GPRS coding schemes over a TU03 channel with and without frequency hopping at C/I=7dB. This is summarized again in Table 2.

[3] Note that this assumption is probably not true. However, the estimation on the SDU error rate is therefore an upper bound to the real error rate.

Table 2

| Payload size and RLC/MAC block loss rates at C/I=7dB, different coding schemes with and without frequency hopping. | | | |
|---|---|---|---|
| | Payload size *N* | 7dB FH | 7dB nFH |
| CS 1 | 20 bytes | 0.133680 | 0.252568 |
| CS 2 | 30 bytes | 0.410720 | 0.337416 |
| CS 3 | 36 bytes | 0.595024 | 0.397168 |
| CS 4 | 50 bytes | 0.929472 | 0.568128 |

2.2 SDU Error Rate versus Throughput

The presented results show the residual RLC-SDU error rate versus throughput for different parameter settings and coding schemes. The equations according to the previous sections have been applied. For the repetition scheme the parameter *K*, the number of repetitions, is varied to trade off throughput versus error rate. *K* is selected as K=1,2,3, ... . In case of the RS code scheme the parameter *k*, the RLC-SDU segment size (corresponding to the RS information word size) is varied accordingly. *k* is selected as *k*=1,2,3,...*n*. In a first set of experiments we apply frequency hopping, multi-slot transmission (M=6), assume *n=M*N* and a constant SDU size of *S=500* bytes. The results for C/I=7dB are shown in Figure 1. Note that only each dot is realizable, the connecting lines are just for illustration purposes.

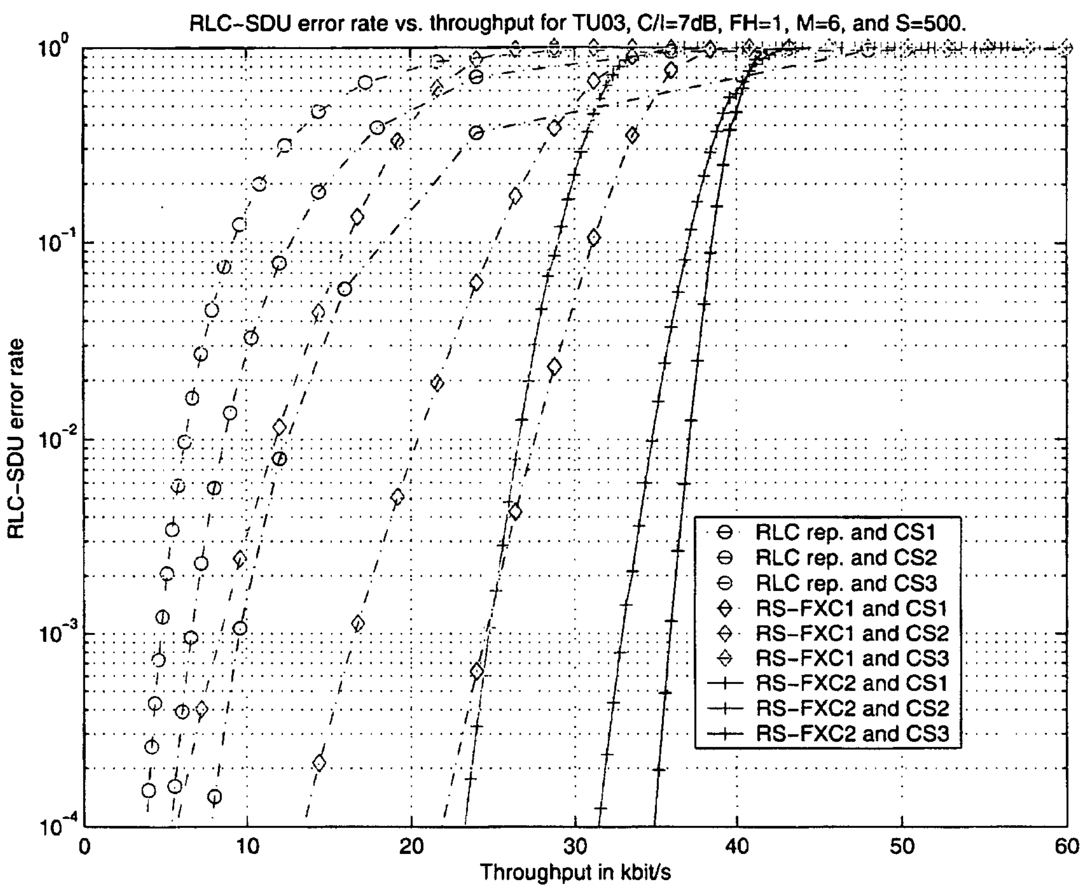


Figure 1 RLC-SDU error rate vs. throughput for TU03 with FH, *S*=500, M=6, and C/I = 7dB.

We will focus on C/I=7dB in the following: Assuming a target RLC-SDU error rate of about 1%, for the repetition schemes only the RLC/MAC block repetition scheme for coding scheme 1 with *K*=4 seems to be appropriate. All other repetition schemes either do not provide sufficient error rate or sufficient throughput. The throughput for K=4 with CS1 is 12 kbit/s (with the assumption that the payload size for CS 1 is 20 bytes, i.e. *N*=20). For the simple outer coding scheme with parallel MDTCHs and a target RLC-SDU error rate of 1% a throughput of 26 kbit/s can be supported using CS1 and k=11, which is 115% more. For the extension to the multislot scheme with interleaving over all 6 MDTCHs a throughput of more than 37 kbit/s can be supported when using k=92 and CS1. This means that compared to the best repetition scheme the throughput is more than tripled when compared to the repetition scheme.

2.3 Delay Estimations

The previous results show the benefits of our proposed extension in terms of throughput and error rate. Another issue is the introduced delay of a RLC-SDU for different schemes, which is also related to the required memory in the mobile and the base station.
The parameters providing a sufficient error rate according to Figure 1 are as follows:
For the repetition code: K=4 with CS1
For the simple scheme RS code with convolutional interleaver : k=11 with CS1
For the extended RS code scheme with convolutional interleaver: k=92 with CS1
Figure 2 shows delay versus RLC-SDU size for different schemes and M=6. In case of multislot transmission the delay for the RLC-SDU repetition obviously decreases by M compared to the single-slot case. A similar result has been obtained for the Reed-Solomon scheme in case of parallel MDTCHs. However, if we apply our extended multislot scheme with interleaving over all MDTCHs with significantly improved throughput, a delay increase has to be accepted. However, the good news on this scheme is that the delay is almost independent of the RLC-SDU size and its value is still no problem for the considered applications, especially for download and play applications. By appropriate parameter adaptation systems can be designed which trade off throughput versus delay in the multislot case.

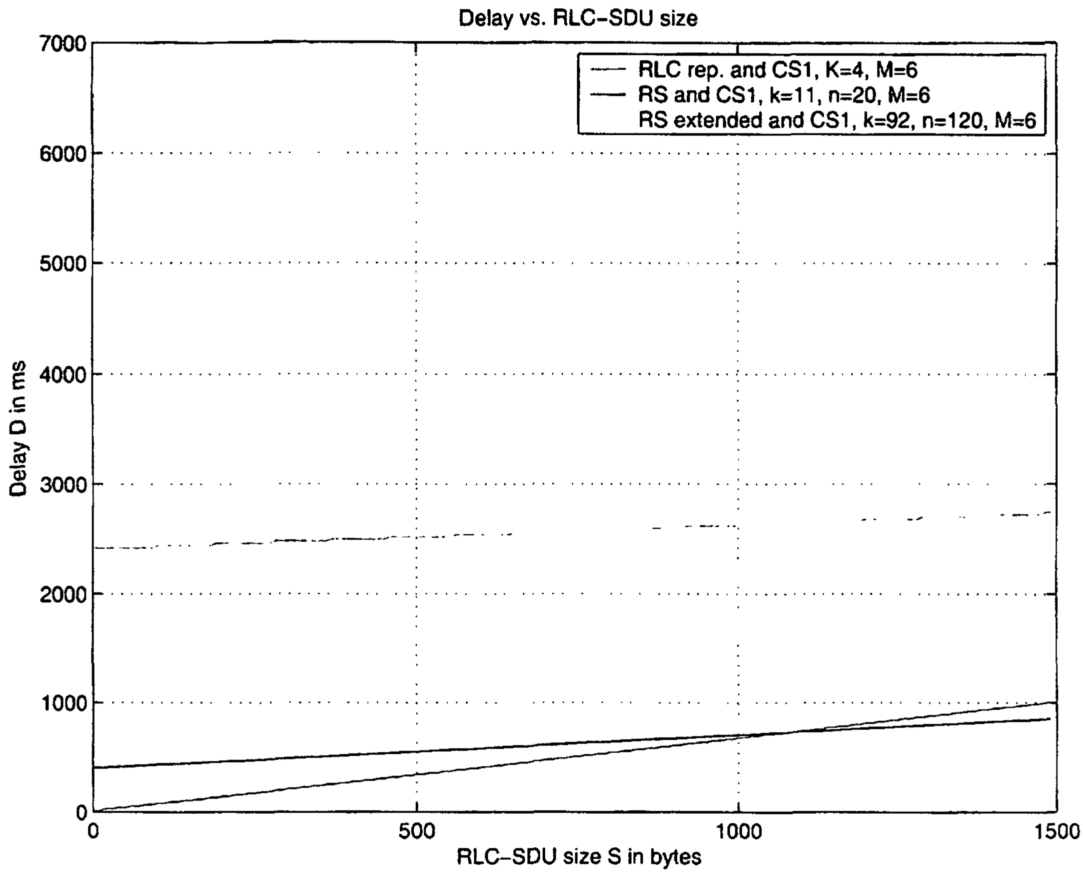


Figure 2 Delay versus RLC SDU size for multi-slot transmission with $M$=6: repetition code with $K$=4 and CS1, RS code with $k$=16 and CS1, and extended RS code scheme with $k$=92 and CS1.

2.4 Simulation Results

To verify the results of our proposed scheme we have implemented the major parts of the algorithms and tested it on realistic GPRS error patterns. Therefore, the assumption of statistically independent RLC/MAC block losses in case of no frequency hopping and statistically independent RLC-SDU segment losses is abandoned and the effects of the interleaver will get more obvious. In addition the effects of block concatenation with respect to RLC-SDUs are considered.

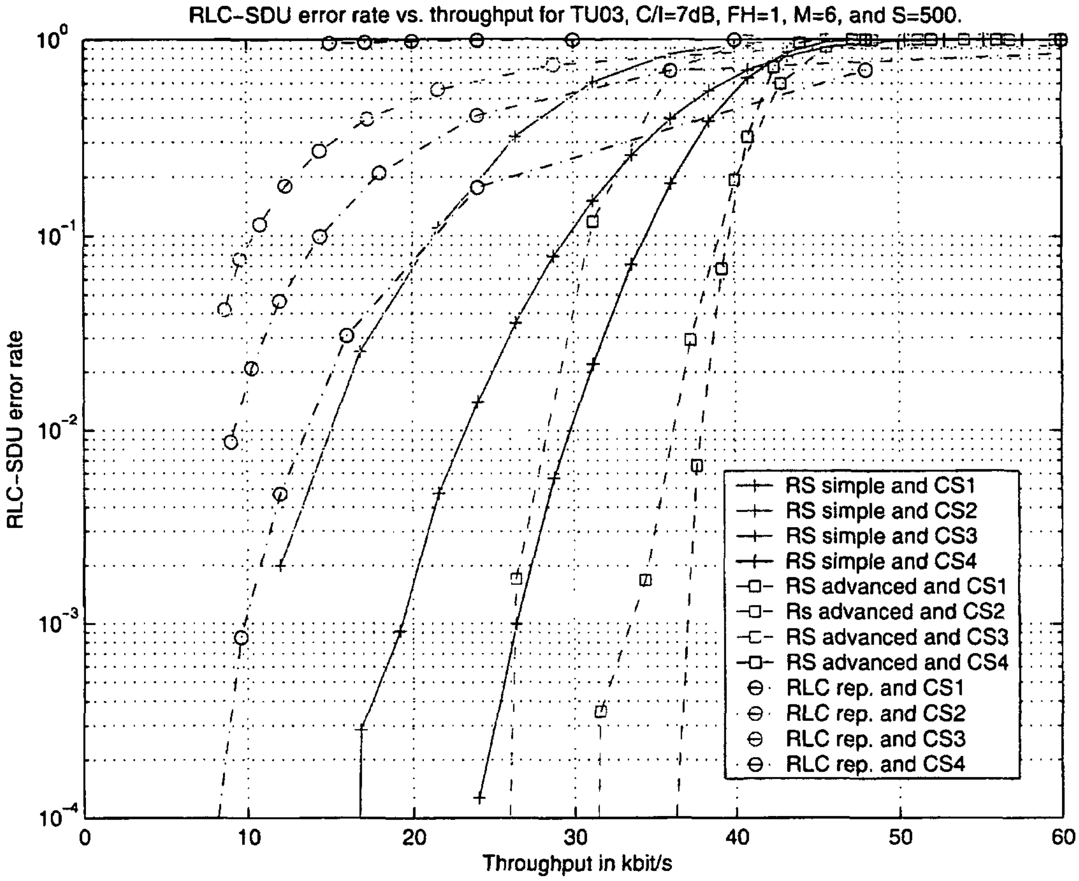


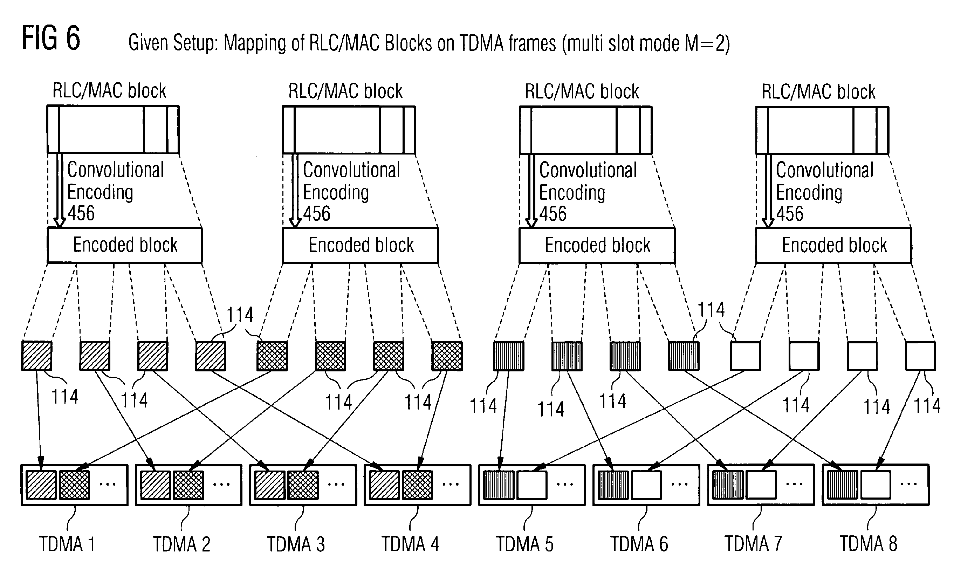

Figure 3 simulated RLC-SDU error rate vs. throughput for TU03 with FH, *S*=500, M=6, and C/I = 7dB.

Figure 3 shows the simulated performance results for the same set of parameters that have been used for the estimation depicted in Figure 1. As one can see, the achievable throughput of the RS coding scheme is again slightly increased, since already a value of *k*=94 is sufficient to yield a RLC-SDU error rate target of 1%. Hence, the performance improvement of the proposed extension to multislot transmission yields an additional gain of 32%.

2.5 REFERENCES

[1] 3GPP TR 25.992-140 "Multimedia Broadcast/Multicast Service (MBMS); UTRAN/GERAN requirements"

[2] 3GPP TS 22.146: "Multimedia Broadcast/Multicast Service; Stage 1".

[3] 3GPP TR 23.846: "Multimedia Broadcast Multicast Service (MBMS); Architecture and Functional Description"

[4] 3GPP TR 25.992: "Multimedia Broadcast Multicast Service (MBMS); UTRAN/GERAN Requirements"

[5] TSG GERAN T-doc GMBMS-0300002. "Performance of MBMS Radio Bearers", Nokia, TSG GERAN MBMS Workshop, Espoo (Finland), 12-13 May 2003.

[6] TSG GERAN T-doc GMBMS-0300007. "On MBMS bearer definition", Siemens, TSG GERAN MBMS Workshop, Espoo (Finland), 12-13 May 2003.

[7] TSG GERAN T-doc GMBMS-0300014. "Bit rate and retransmission aspects for p-t-m MBMS in GERAN", Ericsson, TSG GERAN MBMS Workshop, Espoo (Finland), 12-13 May 2003.

[8] TSG GERAN T-doc GMBMS-030008, "New channel coding schemes for MBMS", Siemens, TSG GERAN MBMS Workshop, Espoo (Finland), 12-13 May 2003.

[9] R1-02-1099, "MBMS design considerations", Qualcomm, RAN1#28, Seattle (USA), 19-22 August 2002.

[10] R1-02-1410, "On support for Outer coding", Qualcomm, RAN1#29, Shanghai (China), 5-8 November 2002.

[11] S. Lin and D. J. Costello, Error *Control Coding,: Fundamentals* and Applications, Englewood Cliffs, N.J.: Prentice Hall, Inc., 1983

[12] GP-030784, "SDU error ratio for streaming when using unacknowledged LLC", Ericsson, GERAN #14, Munich (Germany), 7-11 April 2003

[13] 3GPP TS 22.146, "Multimedia Broadcast/Multicast Service; Stage 1"

[14] 3GPP TS 23.107, "Quality of Service (QoS) concept and architecture"

[15] 3GPP TS 23.246, "Multimedia Broadcast/Multicast Service (MBMS); Architecture and Functional Description"

[16] 3GPP TS 25.346 "Introduction of the Multimedia Broadcast Multicast Service (MBMS) in the Radio Access Network (Stage-2)", version 0.5.0 (March 2003)

[17] J. Rosenberg and H. Schulzrinne, "An RTP Payload Format for Generic Forward Error Correction", Request for Comments 2733, Internet Engineering Task Force, Dec. 1999

[18] C. Perkins and O. Hodson, " Options for Repair of Streaming Media", Request for Comments 2354, Internet Engineering Task Force, June 1998.

[19] Liebl, G.; Stockhammer, T.; Wagner, M.; Pandel, J.; Weng, W.; Base, G.; Nguyen, M.; Burkert, F.: An RTP Payload Format for Erasure-Resilient Transmission of Progressive Multimedia Streams. - In: *Draft-ietf-avt-uxp-*05.txt, Internet Engineering Task Force, March 2003

[20] J.K. Wolf, A.D. Wyner, and J. Ziv, "Source coding for multiple descriptions," Bell System Technical Journal, vol. 59, pp. 1417-1426, October 1980.

[21] Liebl, G.; Stockhammer, T.; Nguyen, T.; Burkert, F.: Erasure-Resilient Multimedia Streaming over Packet Radio Networks. - In: *Proc. 5th World Multiconference on Systemics, Cybernetics and Informatics (SCI 2001), Vol. XII, Orlando, FL, USA,* Juli 2001, pp 328-333.

[22] V. Guruswami and M. Sudan, "Improved decoding of Reed-Solomon codes and algebraic-geometry codes," IEEE Transactions *on Information Theory,* 45(6): 1757--1767, September 1999.

[23] Hagenauer, J.; Offer, E.; Papke, L. : Matching Viterbi Decoders and Reed-Solomon Decoders in a Concatenated System. - In: *In: Reed-Solomon-Codes and* their *Applications,* January 1994, p. 242-271.

[24] J. Byers, M. Luby, and M. Mitzenmacher, "Accessing Multiple Mirror Sites in Parallel: Using Tornado Codes to Speed Up Downloads," Proc. INFOCOM 99.

## Claims

**1.** A method for transmitting a multimedia message via an air interface comprising of the following steps:

- performing a radio link control segmentation
- encoding of the data segments with any channel code
- interleaving/distribution of resulting channel code word over several single user transmission slots.

- Channel decoding/reconstruction at the receiver

**2.** A method according to claim 1, the coding structure such as the information word length and/or the channel word length of the channel code is signalled to the receiving entity.

**3.** A method according to claim 1 or 2, the channel coding being based on Reed-Solomon Coding.

**4.** A method according to any preceding claim, the channel coding being based on error-resilient erasure decoding.

**5.** A method according to claim 1, 2, or 3, the channel coding being based on any soft input and iterative decoding schemes combined with physical layer error protection, equalizers, etc.

**6.** A method according to claim to any preceding claim, the interleaving being based on a convolutional interleaving.

**7.** A method according to claim to any preceding claim, with interleaving such that the segments match the size of the link layer packet, are directly transported, and the channel coding is done over each bit/symbol separately of any number of preceding link layer packets.

**8.** A method according to any preceding claim, parameters of the channel code being automatically adapted to characteristics of transmission channels, the user topology, the delay requirements of the application, and/or the employed modulation scheme.

**9.** A method according to claim 7, The information code word length and the channel code word length of the Reed Solomon code being automatically adapted to characteristics of transmission channels, the user topology, the delay requirements of the application, and/or the employed modulation scheme.

**10.** A method according to claim 7 and 8, The information code word length and the channel code word length of the channel code or Reed Solomon code is being automatically adapted by using shortening or puncturing of the code.

**11.** A method according to any preceding claim, being performed in a GSM/EDGE Radio Access Network.

FIG 1

RS-FXS Scenario 1: RS-code word length n=N (simple multi slot mode M=2)

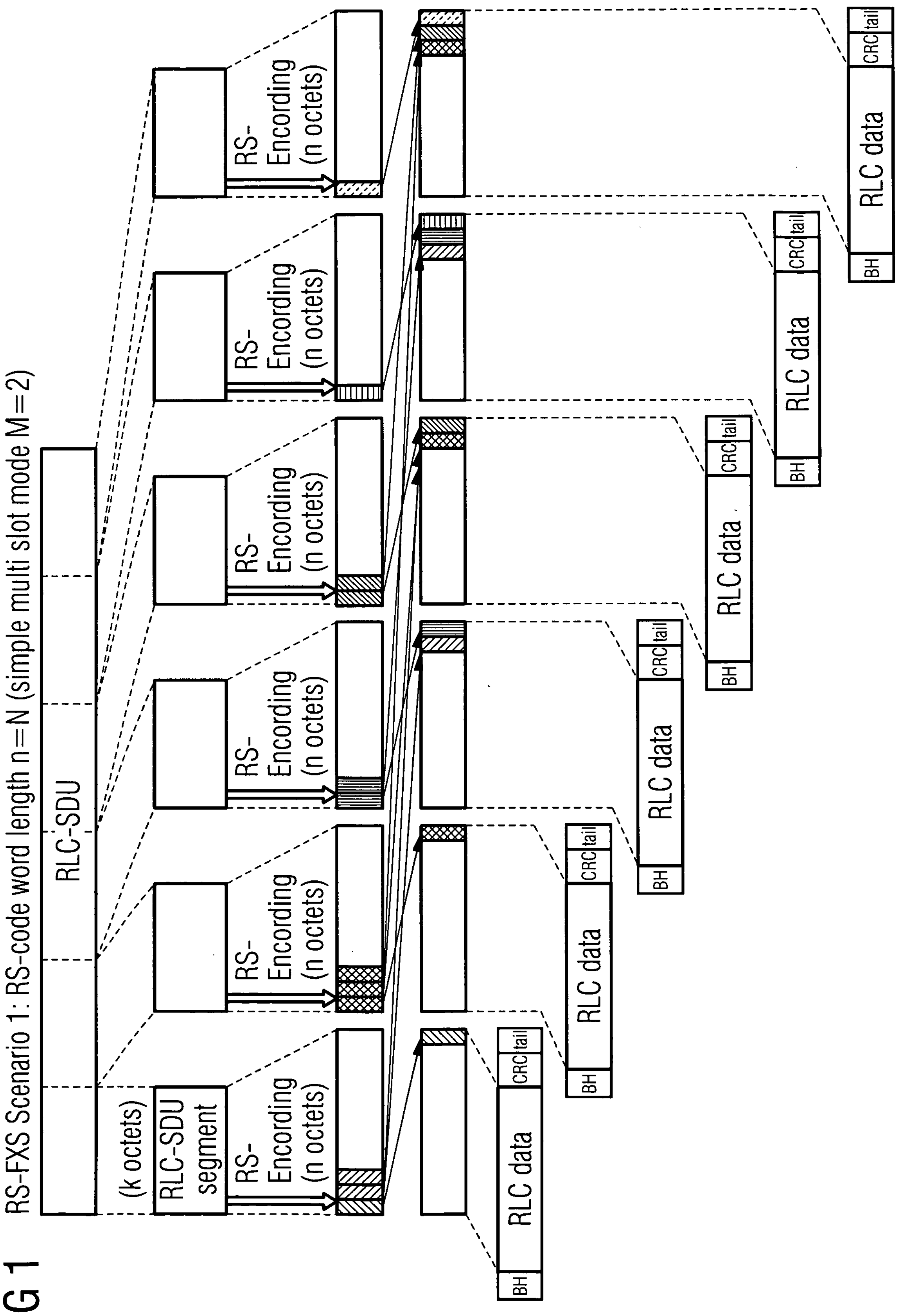

FIG 2

RS-FXS Scenario 2: RS-code word length n=M×N (adv.multi slot mode M=2)

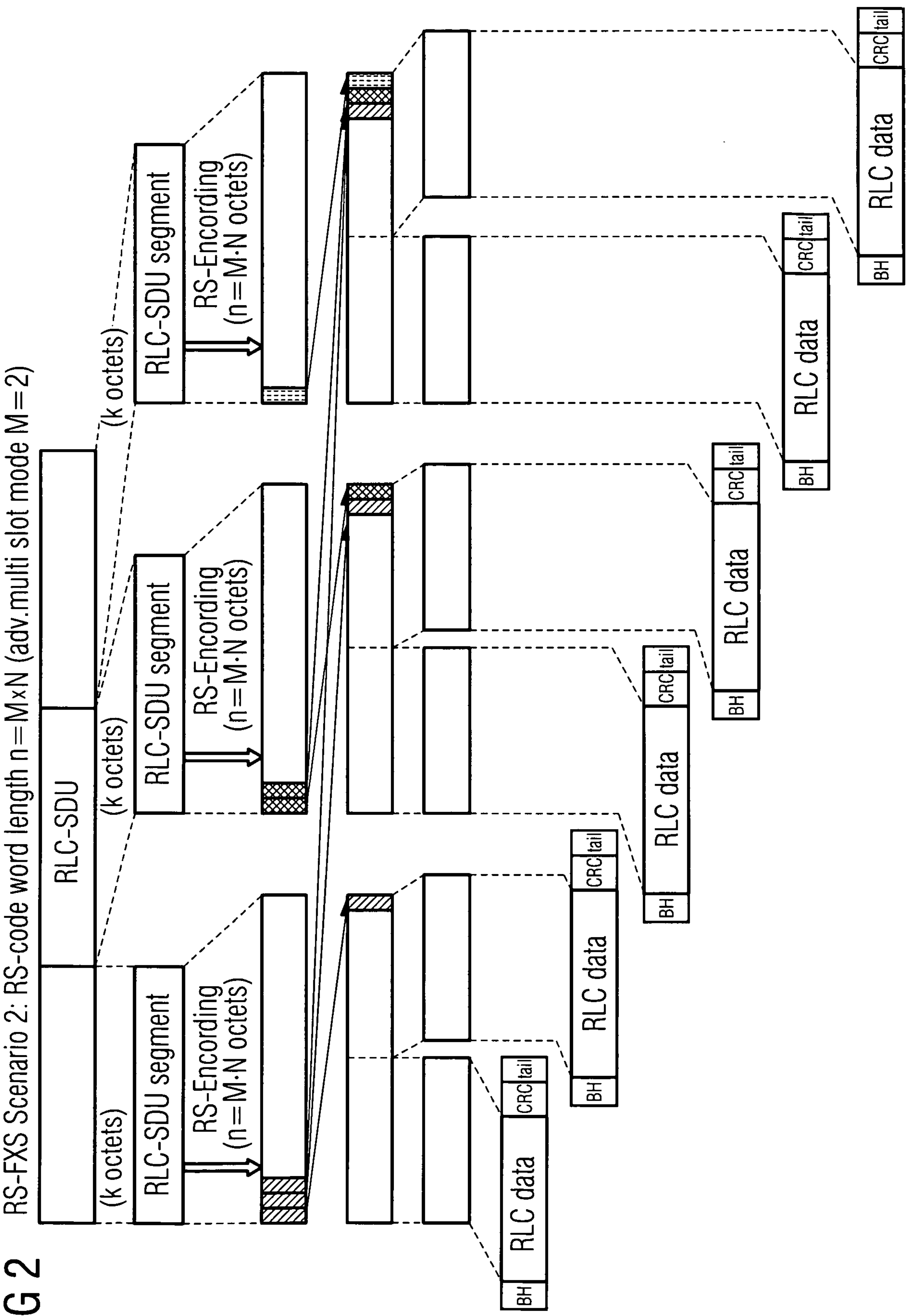

FIG 3

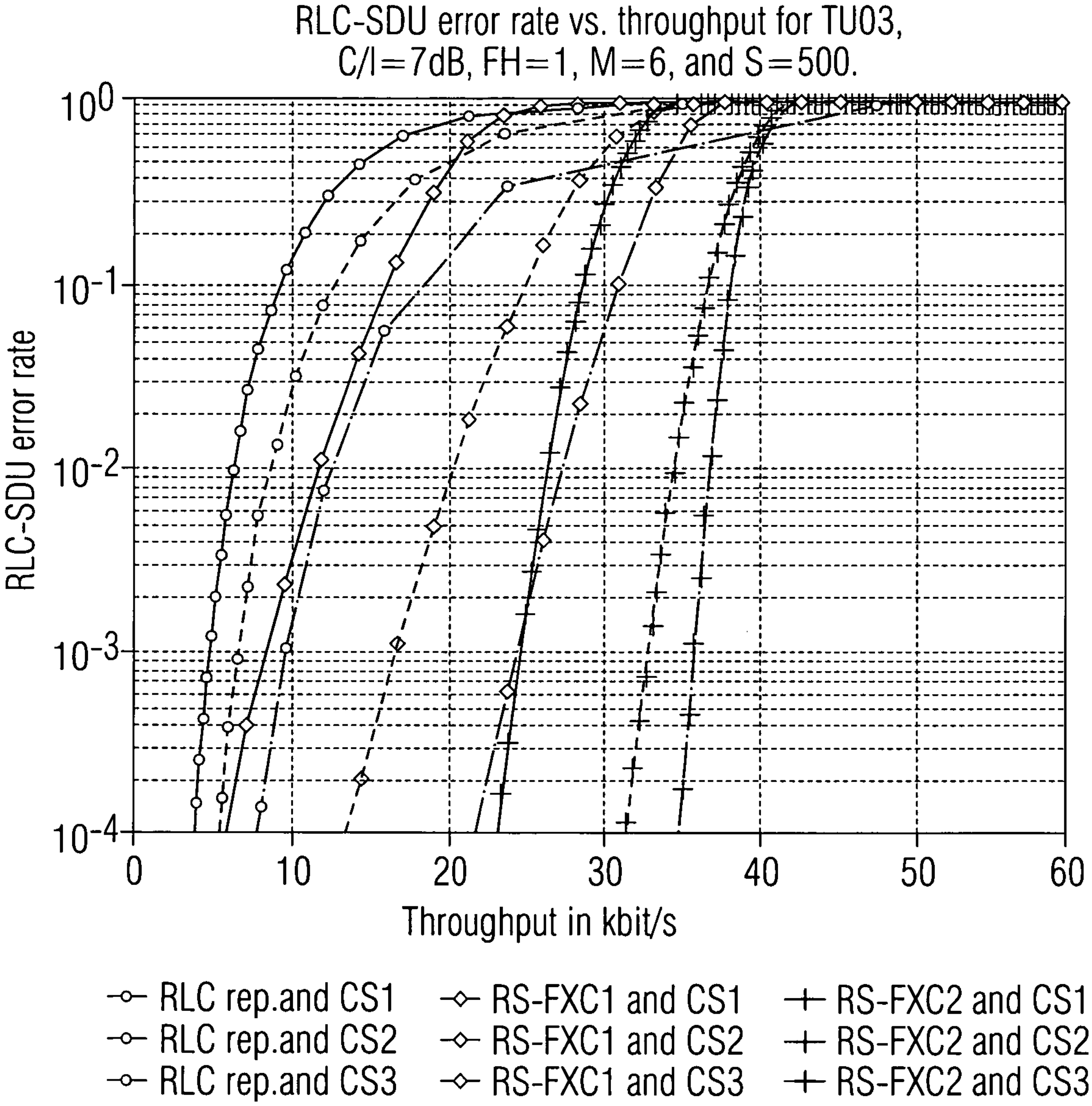
RLC-SDU error rate vs. throughput for TU03,
C/I=7dB, FH=1, M=6, and S=500.
RLC-SDU error rate
$10^0$
$10^{-1}$
$10^{-2}$
$10^{-3}$
$10^{-4}$
0
10
20
30
40
50
60
Throughput in kbit/s
RLC rep.and CS1
RLC rep.and CS2
RLC rep.and CS3
RS-FXC1 and CS1
RS-FXC1 and CS2
RS-FXC1 and CS3
RS-FXC2 and CS1
RS-FXC2 and CS2
RS-FXC2 and CS3

FIG 4

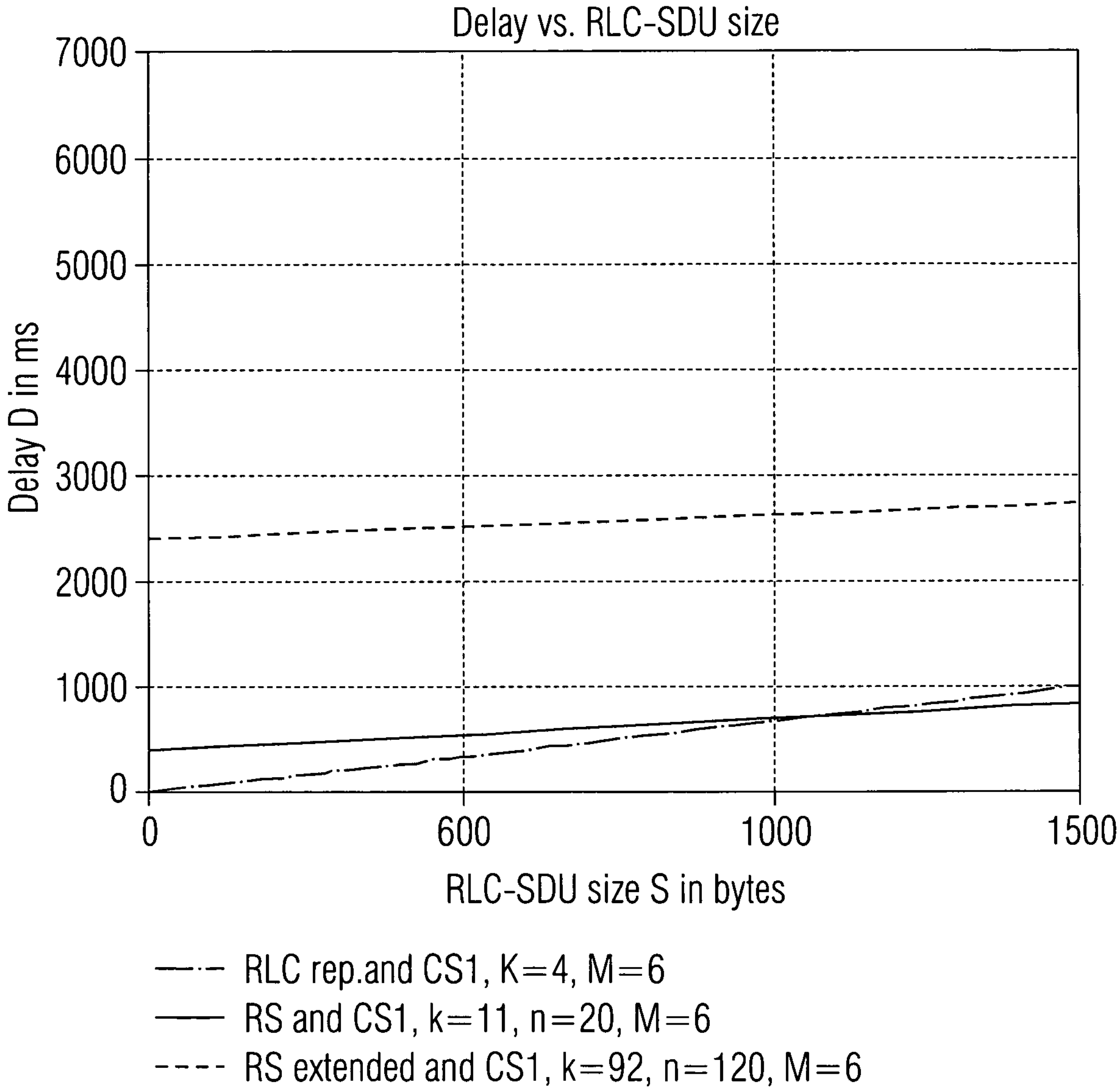
Delay vs. RLC-SDU size
7000
6000
5000
4000
3000
2000
1000
0
Delay D in ms
0
600
1000
1500
RLC-SDU size S in bytes
RLC rep.and CS1, K=4, M=6
RS and CS1, k=11, n=20, M=6
RS extended and CS1, k=92, n=120, M=6

FIG 5

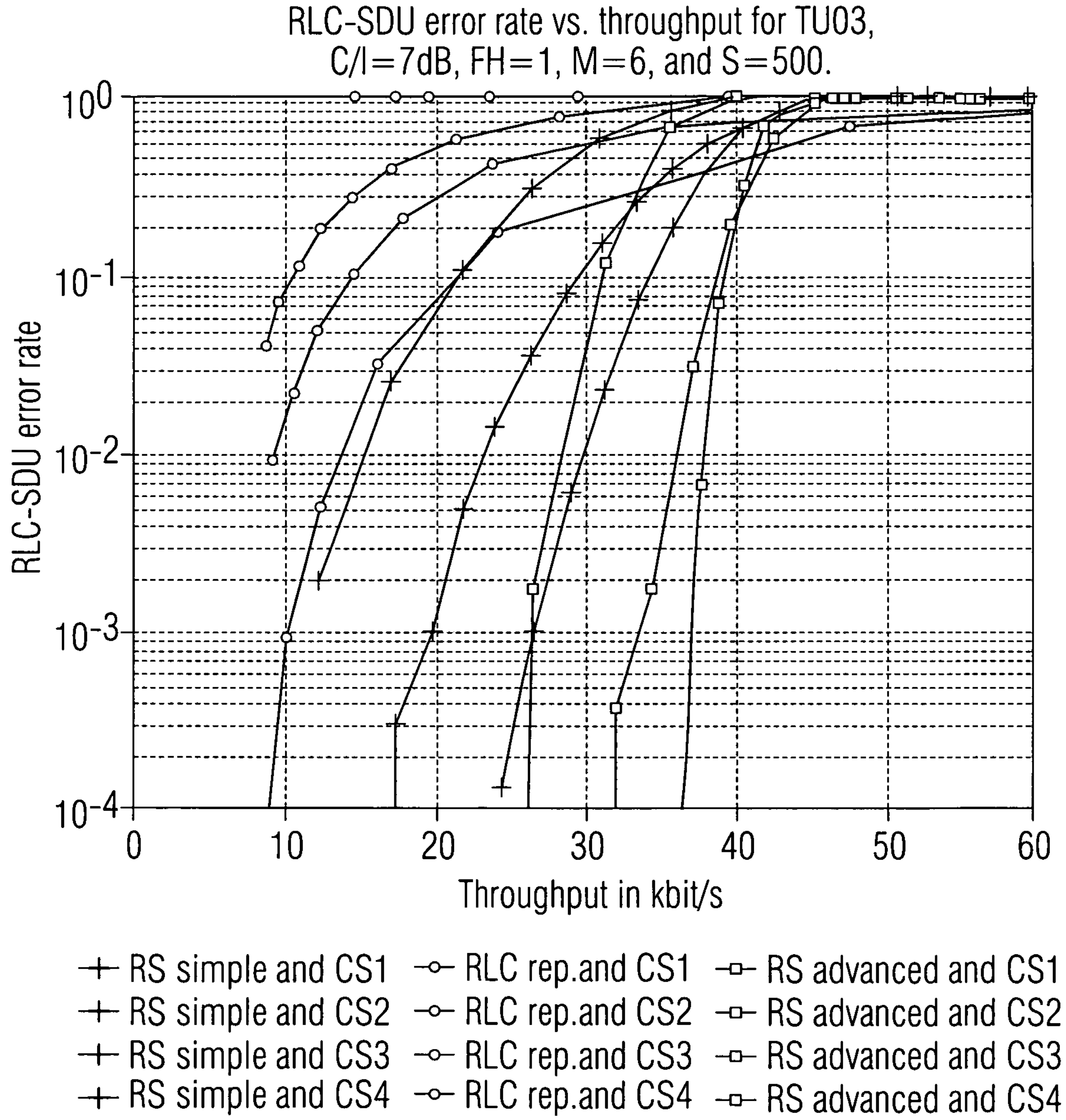
RLC-SDU error rate vs. throughput for TU03,
C/I=7dB, FH=1, M=6, and S=500.
RLC-SDU error rate
$10^0$
$10^{-1}$
$10^{-2}$
$10^{-3}$
$10^{-4}$
0
10
20
30
40
50
60
Throughput in kbit/s
RS simple and CS1
RS simple and CS2
RS simple and CS3
RS simple and CS4
RLC rep.and CS1
RLC rep.and CS2
RLC rep.and CS3
RLC rep.and CS4
RS advanced and CS1
RS advanced and CS2
RS advanced and CS3
RS advanced and CS4

FIG 6 Given Setup: Mapping of RLC/MAC Blocks on TDMA frames (multi slot mode M=2)